# EUROPEAN PATENT APPLICATION

(11) **EP 4 610 916 A1**
(43) Date of publication of application: **03.09.2025**
(21) Application number: 22966855.3
(22) Date of filing: 30.11.2022
(51) Int. Cl.: G06Q 50/06, G01R 31/08

(54) **TOPOLOGICAL GRAPH-BASED MONITORING METHOD, ELECTRONIC DEVICE, AND READABLE MEDIUM**

(71) Applicant: Siemens Aktiengesellschaft, 80333 München (DE)
(72) Inventor: DU, Feng, Shanghai 200120 (CN); DING, Huiping, Shanghai 200335 (CN); JIN, Huiqin, Shanghai 201821 (CN); TAN, Zhiping, Shanghai 200062 (CN); WU, Jianqiang, Shanghai 201100 (CN)
(74) Representative: Isarpatent
(86) International application number: PCT/CN2022/135651
(87) International publication number: WO 2024/113264

(57) **Abstract**

Embodiments of the present disclosure mainly relate to the field of monitoring, and particularly relate to a method for monitoring based on a topology diagram, an electronic apparatus, and a readable medium. A topology diagram corresponding to a circuit system is established. The topology diagram includes a plurality of nodes, a plurality of lines, a connection relationship between the plurality of nodes and the plurality of lines, and a connection relationship between the plurality of lines. Attribute information of each of the plurality of nodes is separately added to a graph database, to instantiate the plurality of nodes. The attribute information of each of the nodes includes: an identity (ID), a type, and a monitoring value. Attribute information of each of the plurality of lines is separately added to the graph database, to instantiate the plurality of lines. The attribute information of each of the lines includes: a length, a resistance, and an inductance. The instantiated topology diagram is displayed on a user interface.

## Description

### TECHNICAL FIELD

Embodiments of the present disclosure mainly relate to the field of monitoring, and particularly relate to a method for monitoring based on a topology diagram, an electronic apparatus, and a readable medium.

### BACKGROUND

Low-voltage distribution is crucial to normal operation of the entire power grid. Thus, it is necessary to monitor a distribution system on the site to ensure continuity and reliability of power supply. Generally, the distribution system involves a large number of hardware devices, communication components and software modules, where a field panel plays an important role in monitoring the distribution system. However, data visualization of the existing field panels is limited, and on-site complexity is not fully considered.

### SUMMARY

Embodiments of the present disclosure provide a method for monitoring based on a topology diagram, an electronic apparatus, and a readable medium, to clearly visualize data for a related circuit system while comprehensively considering on-site complexity.

A first aspect provides a method for monitoring based on a topology diagram. The method includes: establishing a topology diagram corresponding to a circuit system, where the topology diagram includes a plurality of nodes, a plurality of lines, a connection relationship between the plurality of nodes and the plurality of lines, and a connection relationship between the plurality of lines; separately adding attribute information of each of the plurality of nodes to a graph database, to instantiate the plurality of nodes, where the attribute information of each of the nodes includes: an identity (ID), a type, and a monitoring value; separately adding attribute information of each of the plurality of lines to the graph database, to instantiate the plurality of lines, where the attribute information of each of the lines includes: a length, a resistance, and an inductance; and displaying the instantiated topology diagram on a user interface.

A second aspect provides an electronic apparatus. The electronic apparatus includes at least one memory and at least one processor. The at least one memory is used for storing computer-readable codes. The at least one processor is used for invoking the computer-readable codes stored in the at least one memory, to execute all the steps in the method according to the first aspect.

A third aspect provides a computer-readable medium. The computer-readable medium stores computer-readable instructions. When the computer-readable instructions are executed by a processor, the processor is caused to execute all the steps in the method according to the first aspect.

### BRIEF DESCRIPTION OF THE DRAWINGS

The following accompanying drawings are only intended to perform illustrative description and explanation of embodiments of the present disclosure, and are not intended to limit the scope of the embodiments of the present disclosure. In the drawings:
FIG. 1 is a flowchart of a method for monitoring based on a topology diagram according to an embodiment of the present disclosure;
FIG. 2 is a schematic diagram of a topology diagram corresponding to a circuit system according to an embodiment of the present disclosure; and
FIG. 3 is a schematic diagram of an electronic apparatus according to an embodiment of the present disclosure.

### Descriptions of reference numerals:

| | | | | | |
|---|---|---|---|---|---|
| 100: | Method for monitoring based on a topology diagram | 101-104: | Method steps | | |
| 30: | Electronic apparatus | 31: | Memory | 32: | Processor |

### DETAILED DESCRIPTION

The subject described in the description will be discussed herein with reference to illustrative implementations. It is to be understood that, discussion of the implementations is merely intended to make those skilled in the art better understand and implement the subject described in the description, and is not intended to limit the protection scope of the claims, applicability, or examples. Functions and arrangements of the discussed elements may be changed without departing from the protection scope of the content of embodiments of the present disclosure. Various processes or components may be omitted, replaced, or added in each example as required. For example, the described method may be performed in the order different from the order described herein, and steps may be added, omitted or combined. In addition, features described in some examples may be combined in other examples.

As used herein, the terms "comprise", "include" and their variants represent open terms, and mean "comprise but is not limited to" and "include but is not limited to". The term "based on" represents "at least partially based on". The terms "one embodiment" and "an embodiment" represent "at least one embodiment". The term "another embodiment" represents "at least one another embodiment". The terms such as "first" and "second" may represent different objects or the same object. Other definitions may be included explicitly or implicitly. Unless otherwise clearly specified, definitions of one term are consistent in the entire description.

The embodiments of the present disclosure will be described in detail below with reference to the accompanying drawings.

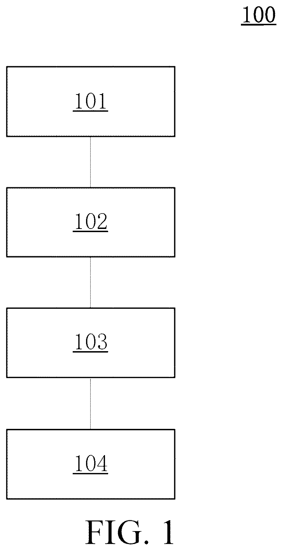

FIG. 1 is a flowchart of a method for monitoring based on a topology diagram according to an embodiment of the present disclosure. As shown in FIG. 1, the method 100 for monitoring based on a topology diagram includes the following steps:
Step 101, a topology diagram corresponding to a circuit system is established. The topology diagram includes a plurality of nodes, a plurality of lines, a connection relationship between the plurality of nodes and the plurality of lines, and a connection relationship between the plurality of lines.
   Optionally, the corresponding topology diagram may be established for the plurality of nodes and related lines specified by a user in the circuit system. Optionally, the corresponding topology diagram may be established for all the nodes and all the lines in the circuit system.
Step 102, attribute information of each of the plurality of nodes is separately added to a graph database, to instantiate the plurality of nodes. The attribute information of each of the nodes includes: an identity (ID), a type, and a monitoring value. Optionally, the monitoring value includes an electrical parameter and/or a temperature.
Step 103, attribute information of each of the plurality of lines is separately added to the graph database, to instantiate the plurality of lines. The attribute information of each of the lines includes: a length, a resistance, and an inductance.
Step 104, the instantiated topology diagram is displayed on a user interface.

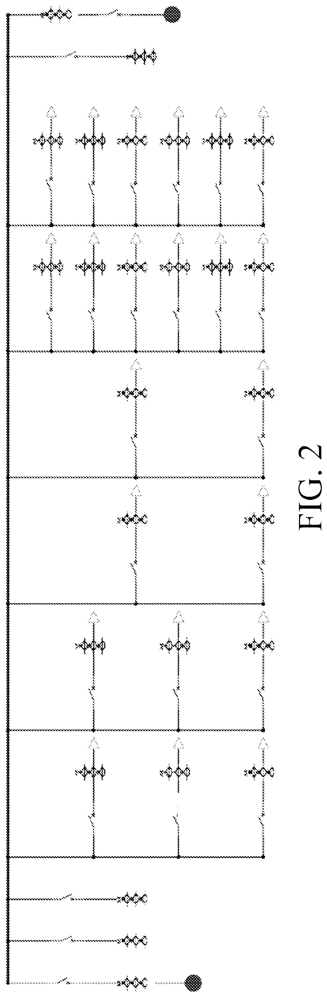

In the embodiment of the present disclosure, firstly, the corresponding topology diagram shown in FIG. 2 is established for the circuit system, then the attribute information of each of the plurality of nodes is separately added to the graph database, and the attribute information of each of the plurality of lines is separately added to the graph database. In this way, the plurality of nodes and the plurality of lines in the topology diagram are instantiated, and then the instantiated topology diagram is displayed on the user interface. Based on comprehensive consideration of on-site complexity, data is clearly visualized for a related circuit system, such that it is convenient for the user to monitor a state of a related node on a display interface, and a basis is provided for various types of digitalization services.

In an embodiment, after step 104, a first application method transmitted by an edge application pool is received. The first application method includes existing application software or a user-defined method. In addition, the embodiment of the present disclosure further specifically provides a first application method. Then, a specified device list input by the user is received. A real-time monitoring value of a specified device in the specified device list is collected. The real-time monitoring value of the specified device is stored at a corresponding position in the graph database, and the first application method is run. An embodiment of the present disclosure designs an edge application pool framework based on an open data bus. Various applications based on real-time data in a topology diagram can be run through connection to an edge application pool. In the prior art, a related application must be configured in a panel. Different from that, the embodiments of the present disclosure implement a distributed deployment mode, such that computational power required by a display system on an edge device can be reduced, and excellent expansibility can be achieved.

In an embodiment, the first application method is as follows: firstly, power consumption of each of the lines in the topology diagram is computed separately at a plurality of preset moments, to obtain a plurality of groups of data. The plurality of groups of data are input into a first artificial intelligence (AI) model for training, to obtain a second AI model. Power consumption of each of the lines in the topology diagram at a current moment is input to the second AI model, and a first loss value of the topology diagram is output through the second AI model. The first loss value is compared with an actual loss value. An alarm is given on the user interface in a case where a preset threshold is exceeded. Optionally, the first AI model is an extremely randomized tree or a neural network model. Optionally, the preset threshold may be any value greater than or equal to 30%. Optionally, the actual loss value is a difference between energy consumption of all sources and energy consumption of all loads in the circuit system. Optionally, the plurality of preset moments may be spaced by 15 minutes for example. Optionally, before model training, update frequency and granularity of a data source and hyper-parameters of a model may be configured. According to the embodiment of the present disclosure, in a case where a predicted value output by the second AI model and the actual loss value are greatly different, the user may be prompted to check possible problems in the entire system.

In an embodiment, power consumption of all the loads and power consumption of all the sources in the topology diagram may be computed at the plurality of preset moments respectively. In addition, the differences between the power consumption of all the loads and the power consumption of all the sources are computed at the plurality of preset moments respectively, to obtain a plurality of groups of data. Specifically, a first group of data in the plurality of groups of data includes: power consumption of all the loads at a first moment, power consumption of all the sources at the first moment, and differences between the power consumption of all the loads and the power consumption of all the sources at the first moment. A training data set obtained in the embodiment of the present disclosure may be used to obtain a model more accurate in prediction through training.

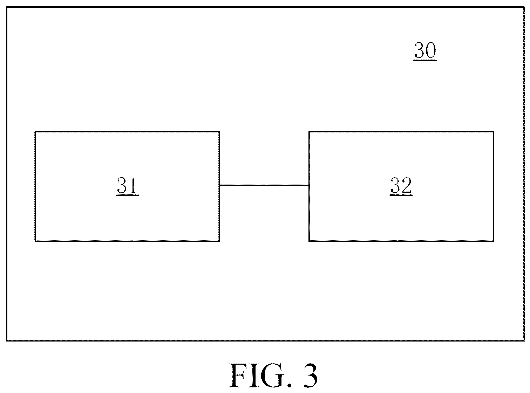

An embodiment of the present disclosure further provides an electronic apparatus 30. FIG. 3 is a schematic diagram of an electronic apparatus 30 according to an embodiment of the present disclosure. As shown in FIG. 3, the electronic apparatus 30 includes a processor 32 and a memory 31. The memory 31 stores instructions. The instructions are executed by the processor 32 to implement the method 100.

The at least one processor 32 may include a microprocessor, an application-specific integrated circuit (ASIC), a digital signal processor (DSP), a central processing unit (CPU), a graphics processing unit (GPU), a state machine, etc. The embodiments of a computer-readable medium include, but are not limited to, a floppy disk, a compact disc read-only memory (CD-ROM), a magnetic disk, a memory chip, a ROM, a random access memory (RAM), an ASIC, a configured processor, an all-optical medium, all magnetic tapes or other magnetic media, or any other media from which a computer processor may read instructions. In addition, the computer-readable medium in various other forms may transmit or carry instructions to a computer, which include a router, a private or public network, or other wired or wireless transmission devices or channels. The instructions may include codes of any computer programming language, which include C, C++, C language, Visual Basic, java, and JavaScript.

In addition, an embodiment of the present disclosure further provides a computer-readable medium. The computer-readable medium stores computer-readable instructions. When the computer-readable instructions are executed by a processor, the processor is caused to execute the method 100 described above. Embodiments of the computer-readable medium include a floppy disk, a hard disk, a magneto-optical disk, an optical disk (for example, a CD-ROM, a compact disk recordable (CD-R), a compact disc rewritable (CD-RW), a digital video disk-read only memory (DVD-ROM), a DVD-RAM, a DVD-RW, or a DVD+RW), a magnetic tape, a non-volatile memory card, and a ROM. Optionally, the computer-readable instructions may be downloaded from a server computer or a cloud through a communication network.

It is to be noted that not all steps and modules in the flows and the diagrams of the system structures are necessary, and some steps or modules may be omitted according to actual needs. An execution order of the steps is not fixed and may be adjusted as required. The system structure described in the embodiments may be a physical structure or a logical structure. That is, some modules may be implemented through a same physical entity, or some modules may be implemented through a plurality of physical entities separately or implemented through some components in a plurality of independent devices jointly.

## Claims

1. A method for monitoring based on a topology diagram, comprising:
- (101) establishing a topology diagram corresponding to a circuit system, wherein the topology diagram comprises a plurality of nodes, a plurality of lines, a connection relationship between the plurality of nodes and the plurality of lines, and a connection relationship between the plurality of lines;
- (102) separately adding attribute information of each of the plurality of nodes to a graph database, to instantiate the plurality of nodes, wherein the attribute information of each of the nodes comprises: an identity (ID), a type, and a monitoring value;
- (103) separately adding attribute information of each of the plurality of lines to the graph database, to instantiate the plurality of lines, wherein the attribute information of each of the lines comprises: a length, a resistance, and an inductance; and
- (104) displaying the instantiated topology diagram on a user interface.

2. The method according to claim 1, wherein after the (104) displaying the instantiated real-time topology diagram on a user interface, the method further comprises:
- receiving a first application method transmitted by an edge application pool;
- receiving a specified device list input by a user;
- collecting a real-time monitoring value of a specified device in the specified device list; and
- storing the real-time monitoring value of the specified device at a corresponding position in the graph database, and running the first application method.

3. The method according to claim 1, wherein the monitoring value comprises an electrical parameter and/or a temperature.

4. The method according to claim 2, wherein the first application method comprises:
- computing power consumption of each of the lines in the topology diagram separately at a plurality of preset moments, to obtain a plurality of groups of data;
- inputting the plurality of groups of data into a first artificial intelligence (AI) model for training, to obtain a second AI model;
- inputting power consumption of each of the lines in the topology diagram at a current moment to the second AI model, and outputting a first loss value of the topology diagram through the second AI model;
- comparing the first loss value with an actual loss value; and
- giving an alarm on the user interface in a case where a preset threshold is exceeded.

5. The method according to claim 4, wherein the actual loss value comprises:
- differences between energy consumption of all sources and energy consumption of all loads in the circuit system.

6. The method according to claim 4, wherein the computing power consumption of each of the lines in the topology diagram separately at a plurality of preset moments, to obtain a plurality of groups of data comprises:
- computing power consumption of all loads and power consumption of all sources in the topology diagram at the plurality of preset moments respectively; and
- computing differences between the power consumption of all the loads and the power consumption of all the sources at the plurality of preset moments respectively, to obtain a plurality of groups of data, wherein a first group of data in the plurality of groups of data comprises: power consumption of all the loads at a first moment, power consumption of all the sources at the first moment, and differences between the power consumption of all the loads and the power consumption of all the sources at the first moment.

7. The method according to claim 4, wherein the first AI model comprises: an extremely randomized tree or a neural network model.

8. An electronic apparatus, comprising:
at least one memory (31) configured to store computer-readable codes; and
at least one processor (32) configured to invoke the computer-readable codes, to execute steps in the method according to any one of claims 1 to 7.

9. A computer-readable storage medium, storing a computer program, wherein the computer program is capable of being executed by a processor and implementing the method according to any one of claims 1 to 7.
